# FASCICULE DE BREVET EUROPEEN

(11) **EP 1 929 625 B1**
(45) Date de publication et mention de la délivrance du brevet: **07.01.2015**
(21) Numéro de dépôt: 06793079.2
(22) Date de dépôt: 30.08.2006
(51) Int. Cl.: H03C 1/36

(54) **PROCEDE ET DISPOSITIF DE CONTROLE DE PUISSANCE CRETE ET DE LARGEUR D'IMPULSION D'UN EMETTEUR DE FORTE PUISSANCE RF IMPULSIONNEL GAUSSIEN LARGE BANDE**
VERFAHREN UND EINRICHTUNG ZUR STEUERUNG VON SPITZENLEISTUNG UND IMPULSBREITE EINES BREITBANDIGEN GAUSSIMPULS-HOCHLEISTUNGS-HF-SENDERS
METHOD AND DEVICE FOR CONTROLLING PEAK POWER AND PULSE WIDTH OF A BROADBAND GAUSSIAN PULSE HIGH-POWER RF TRANSMITTER

(30) Priorité: 30.08.2005 FR 0508875
(43) Date de publication de la demande: 11.06.2008
(73) Titulaire: THALES, 92200 Neuilly sur Seine (FR)
(72) Inventeur: LETEMPLIER, Alain, F-53100 Mayenne (FR)
(74) Mandataire: Dudouit, Isabelle
(86) Numéro de dépôt international: PCT/EP2006/065835
(87) Numéro de publication internationale: WO 2007/025993

(56) Documents cités:
- EP-A- 1 017 162
- US-A- 3 668 533
- US-A- 4 409 594
- US-A- 4 412 337
- US-A- 5 049 832
- US-A- 5 420 536
- US-A- 6 141 390
- US-A1- 2003 184 374
- US-B2- 6 396 345

## Description

L'invention concerne un procédé et un dispositif pour contrôler notamment les paramètres amplitude et puissance d'une impulsion émise par un émetteur de forte puissance.

Elle s'applique, en particulier, pour contrôler la puissance crête et la largeur d'impulsion d'un émetteur de forte puissance RF impulsionnel gaussien large bande.

L'invention s'applique par exemple dans le cas d'émetteur d'impulsions RF quel que soit le type d'impulsions.

Il est connu de l'art antérieur des procédés et des dispositifs permettant de contrôler la puissance crête et la largeur d'impulsion d'un émetteur de forte puissance.

L'utilisation de transistors bipolaires est encore aujourd'hui incontournable pour obtenir des niveaux de puissance crête supérieurs à 500W dans un volume raisonnable.

Une solution habituellement utilisée consiste notamment à contrôler le courant de polarisation émetteur base de n étages classe C base commune successifs, tel que décrit dans le brevet du demandeur EP 06685932.

Un des inconvénients de cette solution est que les éléments de contrôle sont placés en série dans l'alimentation de puissance des transistors bipolaires classe C, engendrant ainsi des pertes diminuant le rendement de l'émetteur. D'autre part, ces types de chaîne d'émission nécessitent l'emploi d'important moyen de refroidissement dès que le taux de charge dépasse 1%, ce qui limite son emploi pour des applications aéroportées dépassant 500W crête, par exemple.

L'intégrité de la forme de l'impulsion RF est difficilement contrôlable dans une large bande de fréquence et une large variation de température de fonctionnement.

Le brevet US 4 412 337 décrit un dispositif offrant une enveloppe d'impulsion préférée qui est comparée à l'enveloppe d'impulsions produite par un amplificateur de puissance non linéaire. Le procédé utilise l'erreur existant entre les deux pour générer des signaux d'erreur représentatifs de la différence entre les enveloppes comparées et va aussi pour générer une enveloppe corrigée.

Le brevet US 2003/0184374 décrit un dispositif de compensation temps réel des non linéarités, amplitude et phase, d'un ampli RF de puissance par une technique de prédistorsion.

L'invention concerne un dispositif de contrôle des paramètres d'une impulsion d'un émetteur de forte puissance RF impulsionnel comprenant au moins un amplificateur, comportant au moins les éléments suivants :
un détecteur de l'impulsion émise couplé à la sortie d'un amplificateur vidéo, un dispositif de traitement analogique couplé à l'amplificateur vidéo et adapté à fournir des informations relatives aux paramètres largeurs et puissance de l'impulsion émise en sortie de l'amplificateur vidéo, un dispositif de traitement numérique de génération de signaux de commande, recevant le signal d'émission, les informations relatives aux paramètres largeur et puissance de l'impulsion et transmettant les signaux de commande vers
   - un dispositif de génération d'un signal de forme sensiblement gaussienne d'amplitude variable
   - un dispositif de génération d'un signal de forme sensiblement carrée d'amplitude variable,
le dispositif est caractérisé en ce qu'il comporte :
   un additionneur sommant le signal de forme sensiblement gaussienne et le signal de forme sensiblement carrée, ledit additionneur étant en liaison avec un amplificateur.

Le dispositif de génération de signal de forme gaussienne est, par exemple, un potentiomètre numérique et le dispositif de génération de signal de forme carrée est un potentiomètre numérique .

Les potentiomètres numériques sont, par exemple, des potentiomètres à commandes « up/down ».

L'invention présente notamment les avantages suivants :
- les signaux de modulation basse tension sont faciles à générer numériquement avec un convertisseur de type analogique-numérique ou DAC et de simples amplificateurs opérationnels,
- l'utilisation de transistors LDMOS limite le nombre d'étages amplificateurs et améliore le rendement de la chaîne d'émission et, par conséquent, donne accès à des taux de charge plus importants sans échauffement excessif. Par exemple, le rendement de l'émetteur peut être amélioré de 20 à 30 %,
- l'invention garantit l'intégrité de l'impulsion gaussienne émise (forme, largeur, etc.),
- elle permet la régulation de la puissance crête dans toute la bande de fréquence,
- elle permet d'obtenir des performances stables en température.

D'autres caractéristiques et avantages de la présente invention apparaîtront mieux à la lecture de la description qui suit, d'un exemple donné à titre illustratif et nullement limitatif, annexée des figures qui représentent :
- la figure 1 un synoptique de l'invention,
- les figures 2A et 2B une série de chronogrammes pour les signaux de commande, de contrôle et les signaux de modulations générées par l'invention,
- la figure 3 un exemple d'architecture pour un amplificateur alimenté en tension pulsée.

Le procédé et le dispositif selon l'invention reposent notamment sur le principe suivant : grâce à une détection du signal émis d'une part et l'utilisation d'un ampli RF à gain variable d'autre part, on génère un signal impulsionnel de forme gaussienne avec un piédestal de pré-polarisation (piédestal ayant notamment pour fonction de polariser l'amplificateur) d'amplitude contrôlée par un système d'asservissement numérisé à destination des étages terminaux de puissance classe C. Le signal de modulation est constitué par l'addition d'une composante de forme gaussienne d'amplitude variable permettant de contrôler la puissance crête et d'une composante carrée d'amplitude variable permettant de générer une prépolarisation du ou des étages terminaux, dans cet exemple, des amplificateurs de classe C, afin d'obtenir une impulsion de forme gaussienne intégralement ou au moins en majorité respectée et de largeur contrôlée.

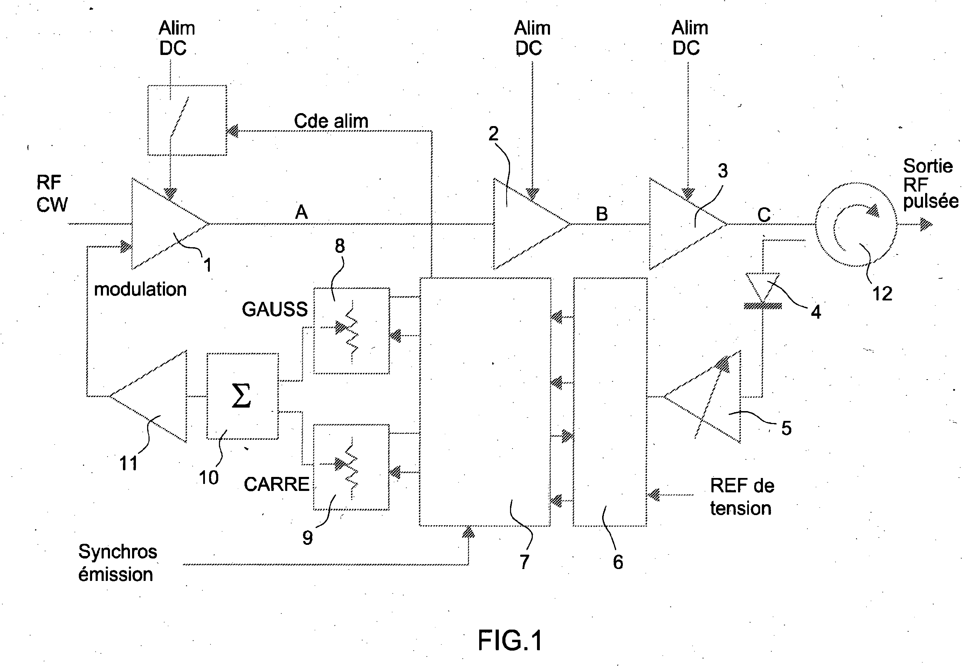

La figure 1 représente un synoptique d'un exemple de système selon l'invention. Le système comporte notamment un premier amplificateur 1 fonctionnant par exemple en classe AB. L'amplificateur est, par exemple, alimenté en tension pulsée. Un deuxième amplificateur 2 disposé à la suite du premier fonctionne en classe C et est alimenté en continu, un troisième amplificateur 3 fonctionne en classe C et est alimenté en continu. Un détecteur d'enveloppe 4 est disposé en fin de chaîne d'amplification et a notamment pour fonction de détecter l'enveloppe du signal émis par la chaîne. Le détecteur est par exemple compensé en température. Le détecteur détecte notamment les impulsions émises dont on extrait une information d'amplitude et une information de largeur.

L'enveloppe détectée est transmise à un ampli vidéo 5 dont la sortie est reliée à un dispositif de traitement analogique 6 qui reçoit une valeur REF de tension. Le dispositif de traitement analogique 6 est en liaison avec un dispositif de traitement numérique 7 qui reçoit les signaux de d'émission.
Le dispositif de traitement numérique 7 génère des signaux de commande et les transmet respectivement à un potentiomètre numérique 8 afin de générer un signal de forme gaussienne et à un potentiomètre numérique 9 afin de générer un signal de forme carrée. Les deux signaux sont ensuite sommés dans un additionneur 10. Le signal formé par la somme des deux signaux est ensuite transmis à un amplificateur 11 avant d'être envoyé au premier amplificateur 1.

De manière plus détaillée :
le dispositif de traitement analogique 6 fournit notamment :
   ▪ une information VMAX si l'amplitude crête de l'émission détectée est supérieure au seuil max (K1 x REF de tension),
   ▪ une information VMIN si l'amplitude crête de l'émission détectée est inférieure au seuil min (K2 x REF de tension),
   ▪ une impulsion de largeur représentative de l'impulsion émise détectée prise à 5 ou 10% de l'amplitude max (discrimination plus facile pour un signal de type gaussien) ;
le dispositif de traitement numérique 7 fournit notamment :
   ▪ le signal de commande de l'alimentation pulsée de l'étage modulateur classe AB synchronisé sur l'émission,
   ▪ les signaux de commande d'un convertisseur analogique numérique DAC et d'un potentiomètre numérique permettant de générer un signal de forme gaussienne d'amplitude variable synchronisé avec la synchro émission,
   ▪ les signaux de commande d'un commutateur analogique et d'un potentiomètre numérique permettant de générer un signal de forme carrée d'amplitude variable synchronisé avec la synchro émission,
   ▪ les commandes des potentiomètres numériques sont du type "up / down", un seul incrément ou décrément est envoyé à chaque synchro émission en fonction des informations reçues du traitement analogique, Amplitude trop forte ou trop faible, largeur trop forte ou trop faible.

Le choix de la puissance crête en sortie se fait par exemple en ajustant le gain de l'ampli vidéo.

La stabilité en température du système ne dépend que de la stabilité du détecteur et de l'ampli vidéo, les autres variations sont automatiquement compensées par l'asservissement.

La stabilité en fréquence du système ne dépend que de la sensibilité en fréquence du coupleur et du détecteur, les autres variations sont automatiquement compensées par l'asservissement.

L'ajout d'un circulateur 12 en sortie d'étage permet notamment d'augmenter l'immunité du système aux conditions d'adaptation en sortie si la directivité du coupleur est insuffisante.

La précision de la puissance crête ne dépend que de la sensibilité en fréquence et en température de l'ensemble coupleur, détecteur, ampli vidéo et du circulateur.

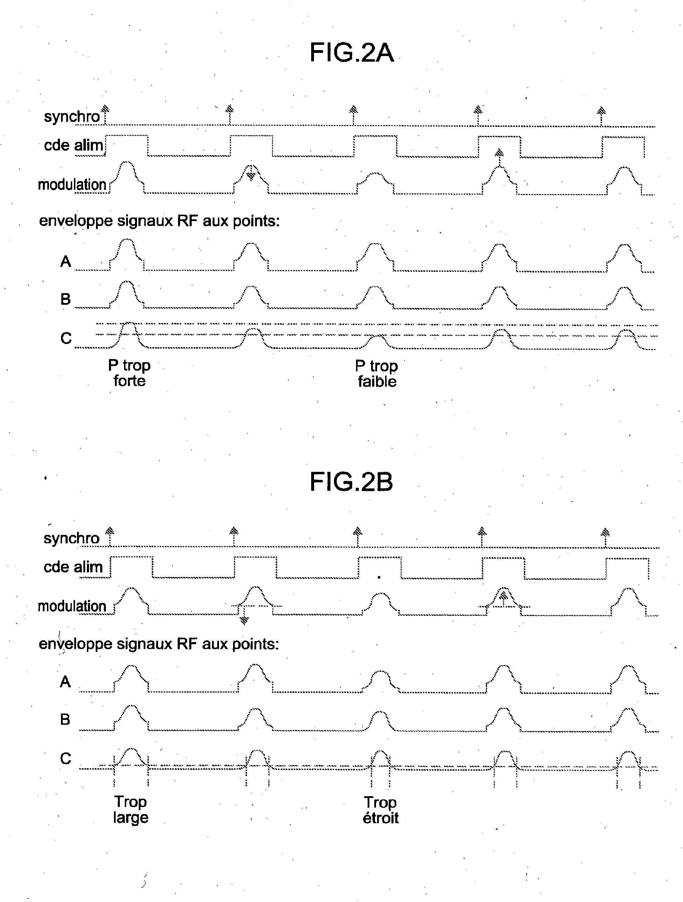

La figure 2 représente les chronogrammes de la commande synchro émission reçue par le dispositif de traitement numérique, de la commande alimentation pulsée de l'amplificateur 1, de la modulation générée par le système selon l'invention et appliquée à l'entrée de la chaîne d'amplification au niveau du premier amplificateur.

Sur la partie 2A, les signaux sont représentés avec le contrôle de la puissance. On a décrit le signal de synchronisation, le signal de commande alimentation, et l'enveloppe aux points A, B et C de la figure 1.

Sur la partie 2B, les signaux sont représentés avec le contrôle de la largeur. De la même façon, les signaux de synchronisation, de commande alimentation et le signal de modulation sont représentés. La figure représente aussi l'enveloppe des signaux RF aux points A, B et C de la figure 1.

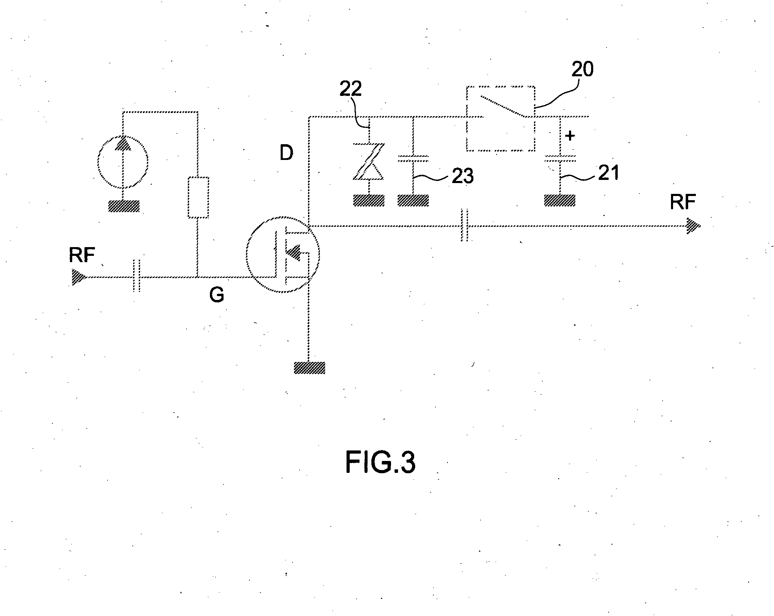

La figure 3 représente un transistor LDMOS fonctionnant en régime impulsionnel en amplification RF de puissance.

La grille G du transistor reçoit le signal modulé en fréquence et est alimentée par une alimentation de grille. Le drain D est relié à une alimentation DC au moyen d'un commutateur 20 faible perte. Le commutateur 20 est commandé au moyen du signal de synchronisation sync d'émission du signal modulé. Le courant de drain n'est présent que lorsque le drain est alimenté. Un dispositif d'écrêtage bi-directionnel rapide de tension, 22, valeur comprise entre l'alimentation crête du drain et la tension de claquage drain source du transistor LDMOS, offre une protection efficace contre les surtensions inhérentes à ce type de fonctionnement. La capacité 23 permet un découplage radiofréquence RF.

L'énergie instantanée nécessaire est fournie par une capacité réservoir 21 de forte valeur calculée en fonction du taux de charge de l'émetteur et faible résistance en série. Ce choix technologique permet notamment de minimiser les pertes.

Le commutateur faible perte est réalisé par exemple à partir de transistors MOSPOWER. Il est donc facilement réalisable et offre toutes les qualités de tenue au courant de drain crête élevé et de faibles pertes L'alimentation VG de la grille peut être :
- une tension continue variable de commande de gain, par exemple un ampli à gain variable,
- un signal de modulation pour un étage utilisé comme un modulateur,
- la tension de grille est contrôlable en amplitude, ajustage du courant de drain de repos, ajustage du gain RF de l'étage.

## Revendications

1. Dispositif de contrôle des paramètres d'une impulsion d'un émetteur de forte puissance RF impulsionnel comprenant au moins un amplificateur comportant au moins les éléments suivants :
un détecteur (4) de l'impulsion émise couplé à la sortie d'au moins un amplificateur vidéo (5),
un dispositif de traitement analogique (6) couplé à l'amplificateur vidéo et adapté à fournir des informations relatives aux paramètres largeurs et puissance de l'impulsion émise en sortie de l'amplificateur vidéo,
un dispositif de traitement numérique (7) de génération de signaux de commande, recevant le signal d'émission et les informations relatives aux paramètres largeur et puissance de l'impulsion, et transmettant lesdits signaux de commande vers:
• un dispositif (8) de génération d'un signal de forme sensiblement gaussienne d'amplitude variable,
• un dispositif (9) de génération d'un signal de forme sensiblement carrée d'amplitude variable synchronisé avec la synchro émission,
**caractérisé en ce qu'**il comporte :
un additionneur (10) sommant le signal de forme sensiblement gaussienne et le signal de forme sensiblement carrée, ledit additionneur (10) étant en liaison avec un amplificateur (11).

2. Dispositif selon la revendication 1 **caractérisé en ce que** le dispositif (8) de génération de signal de forme gaussienne comprend un convertisseur analogique numérique DAC et un potentiomètre numérique.

3. Dispositif selon la revendication 1 **caractérisé en ce que** le dispositif (8) de génération de signal de forme gaussienne est un potentiomètre numérique et le dispositif (9) de génération de signal de forme carrée est un potentiomètre numérique .

4. Dispositif selon la revendication 3 **caractérisé en ce que** les potentiomètres numériques sont des potentiomètres à commandes « up/down ».

5. Dispositif selon la revendication 1 **caractérisé en ce qu'**il comprend un circulateur (12) disposé avant l'ampli vidéo (5).

6. Dispositif selon la revendication 1 **caractérisé en ce que** l'alimentation du premier amplificateur de la chaîne est une alimentation en tension pulsée.

7. Procédé pour contrôler, au moyen du dispositif selon l'une des revendications 1 à 6, les paramètres d'une impulsion émise par un émetteur de forte puissance RF impulsionnel **caractérisé en ce qu'**il comporte au moins les étapes suivantes :
• prélever une partie de l'impulsion émise par l'émetteur et détecter son enveloppe,
• comparer l'amplitude crête de l'émission détectée à une valeur seuil et fournir une information Vmax ou Vmin,
• générer une impulsion de largeur représentative de l'impulsion émise détectée prise à un pourcentage donné de l'amplitude max,
• générer des signaux de commande vers un dispositif adapté à générer un signal de forme gaussienne d'amplitude variable synchronisé avec la synchro émission,
• générer des signaux de commande d'un dispositif adapté à générer un signal de forme sensiblement carrée d'amplitude variable synchronisé avec la synchro émission.

## Patentansprüche

1. Vorrichtung zum Regeln von Parametern eines Impulses eines Hochleistungs-RF-Impulssenders mit wenigstens einem Verstärker, wobei die Vorrichtung wenigstens die folgenden Elemente umfasst:
einen Sendeimpulsdetektor (4), gekoppelt mit dem Ausgang von wenigstens einem Videoverstärker (5);
eine mit dem Videoverstärker gekoppelte analoge Verarbeitungsvorrichtung (6) zum Bereitstellen von Informationen über die Breiten- und Leistungsparameter des gesendeten Impulses am Ausgang des Videoverstärkers;
eine digitale Verarbeitungsvorrichtung (7) zum Erzeugen von Steuersignalen, zum Empfangen des Sendesignals und der Informationen über die Breiten- und Leistungsparameter des Impulses und zum Senden der Steuersignale zu:
einer Vorrichtung (8) zum Erzeugen eines im Wesentlichen gaußförmigen Signals mit veränderlicher Amplitude;
• einer Vorrichtung (9) zum Erzeugen eines im Wesentlichen rechteckigen Signals mit veränderlicher Amplitude, synchronisiert mit der Sendesynchronisation,
**dadurch gekennzeichnet, dass** sie Folgendes umfasst:
ein Addierglied (10) zum Addieren des im Wesentlichen gaußförmigen Signals und des im Wesentlichen rechteckigen Signals, wobei das Addierglied (10) mit einem Verstärker (11) in Verbindung ist.

2. Vorrichtung nach Anspruch 1, **dadurch gekennzeichnet, dass** die Vorrichtung (8) zum Erzeugen eines gaußförmigen Signals einen Analog-Digital-Wandler DAC und ein digitales Potentiometer umfasst.

3. Vorrichtung nach Anspruch 1, **dadurch gekennzeichnet, dass** die Vorrichtung (8) zum Erzeugen eines gaußförmigen Signals ein digitales Potentiometer ist und die Vorrichtung (9) zum Erzeugen eines rechteckigen Signals ein digitales Potentiometer ist.

4. Vorrichtung nach Anspruch 3, **dadurch gekennzeichnet, dass** die digitalen Potentiometer "Auf/Ab"-Steuerpotentiometer sind.

5. Vorrichtung nach Anspruch 1, **dadurch gekennzeichnet, dass** sie einen Zirkulator (12) umfasst, der vor dem Videoverstärker (5) angeordnet ist.

6. Vorrichtung nach Anspruch 1, **dadurch gekennzeichnet, dass** die Stromversorgung des ersten Verstärkers der Kette eine Pulsspannungsversorgung ist.

7. Verfahren zum Regeln, mittels der Vorrichtung nach einem der Ansprüche 1 bis 6, der Parameter eines von einem Hochleistungs-RF-Impulssenders gesendeten Impulses, **dadurch gekennzeichnet, dass** es wenigstens die folgenden Schritte beinhaltet:
• Abtasten eines Teils des von dem Sender gesendeten Impulses und Erkennen seiner Hüllkurve;
• Vergleichen der Spitzenamplitude der erkannten Sendung mit einem Schwellenwert und Bereitstellen einer Information Vmax oder Vmin;
• Erzeugen eines Impulses mit einer Breite, die für den erkannten gesendeten Impuls repräsentativ ist, genommen an einem gegebenen Prozentanteil der maximalen Amplitude;
• Erzeugen von Steuersignalen zu einer Vorrichtung zum Erzeugen eines gaußförmigen Signals mit veränderlicher Amplitude, synchronisiert mit der Sendesynchronisation;
• Erzeugen von Steuersignalen für eine Vorrichtung zum Erzeugen eines im Wesentlichen rechteckigen Signals mit veränderlicher Amplitude, synchronisiert mit der Sendesynchronisation.

## Claims

1. A device for controlling the parameters of a pulse of a high-power RF pulse emitter comprising at least one amplifier, said device comprising at least the following elements:
a detector (4) of the emitted pulse connected to the output of at least one video amplifier (5);
an analogue processing device (6) connected to said video amplifier and designed to provide information relating to the width and power parameters of the emitted pulse at the output of said video amplifier;
a digital processing device (7) for generating control signals, receiving the transmission signal and the information relating to the width and power parameters of the pulse, and
transmitting said control signals to:
• a device (8) for generating a variable amplitude signal of substantially Gaussian shape;
• a device (9) for generating a variable amplitude signal of substantially square shape synchronised with the transmission synchronisation,
**characterised in that** it comprises:
an adder (10) adding together the substantially Gaussian shaped signal and the substantially square shaped signal, said adder (10) being associated with an amplifier (11).

2. The device according to claim 1, **characterised in that** said device (8) for generating a Gaussian shaped signal comprises an analog-digital converter DAC and a digital potentiometer.

3. The device according to claim 1, **characterised in that** said device (8) for generating a Gaussian shaped signal is a digital potentiometer and said device (9) for generating a square shaped signal is a digital potentiometer.

4. The device according to claim 3, **characterised in that** said digital potentiometers are "up/down" control potentiometers.

5. The device according to claim 1, **characterised in that** it comprises a circulator (12) disposed in front of said video amplifier (5).

6. The device according to claim 1, **characterised in that** the power supply for the first amplifier of the chain is a pulsed voltage power supply.

7. A method for controlling, by means of the device according to any one of claims 1 to 6, the parameters of a pulse emitted by a high-power RF pulse emitter, **characterised in that** it comprises at least the following steps:
• taking part of the pulse emitted by said transmitter and detecting its envelope;
• comparing the peak amplitude of the detected emission with a threshold value and providing Vmax or Vmin information;
• generating a pulse with a width that represents the detected emitted pulse taken at a given percentage of the maximum amplitude;
• generating control signals toward a device adapted to generate a variable amplitude signal of Gaussian shape synchronised with the transmission synchronisation;
• generating control signals for a device adapted to generate a variable amplitude signal of substantially square shape synchronised with the transmission synchronisation.
